(19) Europäisches Patentamt
European Patent Office
Office européen des brevets

(11) EP 4 788 078 A1

(12) EUROPEAN PATENT APPLICATION
published in accordance with Art. 153(4) EPC

(43) Date of publication:
05.08.2026 Bulletin 2026/32

(51) International Patent Classification (IPC):
H05K 9/00 (2006.01)   H01Q 15/14 (2006.01)
H01Q 17/00 (2006.01)

(21) Application number: 24871574.0

(22) Date of filing: 19.08.2024

(52) Cooperative Patent Classification (CPC):
H01Q 15/14; H01Q 17/00; H05K 9/00

(86) International application number:
PCT/JP2024/029284

(87) International publication number:
WO 2025/069772 (03.04.2025 Gazette 2025/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 26.09.2023 JP 2023163012

(71) Applicant: LINTEC CORPORATION
Itabashi-ku
Tokyo 173-0001 (JP)

(72) Inventors:
• SEKI, Yuta
Tokyo 173-0001 (JP)
• MATSUSHITA, Taiga
Tokyo 173-0001 (JP)
• TODAKA, Masaya
Tokyo 173-0001 (JP)

(74) Representative: Mathys & Squire
32 London Bridge Street
The Shard
London SE1 9SG (GB)

(54) ELECTROMAGNETIC WAVE ABSORBING MEMBER

(57) An electromagnetic wave absorbing member comprises a resistive layer including a conductive pattern, wherein: the resistive layer includes a first region and a second region having different electromagnetic wave transmission characteristics; the first region has a conductive pattern including a plurality of first arrays in which a plurality of first units are arranged, and a plurality of second arrays in which a plurality of second units different from the first units are arranged; the second region has a conductive pattern including a plurality of the first arrays, and a plurality of the second arrays; a plurality of the first units and a plurality of the second units are arranged in a first direction in the first region; a plurality of the first units and a plurality of the second units are arranged in a second direction different from the first direction in the second region; and the first array and the second array are arranged adjacent to each other in the first region and the second region.

Fig. 2

**Description**

[Technical Field]

The present invention relates to an electromagnetic wave absorbing member.

[Background Art]

Sheet-shaped electromagnetic wave absorbing members that selectively absorb electromagnetic waves of a predetermined frequency are known. In such an electromagnetic wave absorbing member, fine line patterns of Frequency Selective Surface (FSS) elements formed by a conductor can shield electromagnetic waves of a predetermined frequency (Patent Document 1).

[Citation List]

[Patent Literature]

Patent Document 1: JP 6861907 B

[Summary of Invention]

[Technical Problem]

Here, in the FSS element, impedance changes depending on the polarization direction of the incident electromagnetic waves, and electromagnetic wave absorption characteristics may deteriorate. Therefore, when used as an electromagnetic wave absorbing member, the electromagnetic wave absorption characteristics may deteriorate in a case where the polarization direction of electromagnetic waves incident on the electromagnetic wave absorbing member is different from the direction with high electromagnetic wave absorption characteristics.

The present invention has been made in view of the above problem, and an object of the present invention is to provide an electromagnetic wave absorbing member having stable performance regardless of the polarization direction of incident electromagnetic waves.

[Solution to Problem]

To solve the problem described above, the electromagnetic wave absorbing member according to the present invention includes the following aspects.

[1] An electromagnetic wave absorbing member comprising a resistive layer including a conductive pattern, wherein:

the resistive layer includes a first region and a second region having different electromagnetic wave transmission characteristics;
the first region has a conductive pattern including
a plurality of first arrays in which a plurality of first units are arranged, and
a plurality of second arrays in which a plurality of second units different from the first units are arranged;
the second region has a conductive pattern including
a plurality of the first arrays, and
a plurality of the second arrays;
a plurality of the first units and a plurality of the second units are arranged in a first direction in the first region;
a plurality of the first units and a plurality of the second units are arranged in a second direction different from the first direction in the second region; and
the first array and the second array are arranged adjacent to each other in the first region and the second region.

[2] The electromagnetic wave absorbing member according to [1], wherein:

the first region includes a plurality of third arrays in which a plurality of third units different from both the first unit and the second unit are arranged;
the second region includes a plurality of the third arrays;
the third units are arranged in the first direction in the first region; and

the third units are arranged in the second direction in the second region.

[3] The electromagnetic wave absorbing member according to [1] or [2], wherein the conductive pattern of the second region is a pattern obtained by at least rotating or inverting the conductive pattern of the first region.

[4] The electromagnetic wave absorbing member according to any one of [1] to [3], wherein the first region and the second region are repeatedly arranged at regular spacings.

[5] The electromagnetic wave absorbing member according to any one of [1] to [4], wherein:

the resistive layer further includes a third region and a fourth region having different electromagnetic wave transmission characteristics;
the third region has a conductive pattern including
a plurality of arrays in which a plurality of fourth units are arranged in the first direction, and
a plurality of arrays in which a plurality of fifth units different from the fourth units are arranged in the first direction;
the fourth region has a conductive pattern including
a plurality of arrays in which the plurality of fourth units are arranged in the second direction, and
a plurality of arrays in which the plurality of fifth units are arranged in the second direction;
the first region and the third region are different from each other in at least one of a spacing between the arrays of the conductive pattern, a shape of the unit included in the array, a dimension of the unit, and a spacing between the units; and
the second region and the fourth region are different from each other in at least one of a spacing between the arrays of the conductive pattern, a shape of a unit included in the array, a dimension of the unit, and a spacing between the units.

[6] The electromagnetic wave absorbing member according to [5], wherein

the third region includes a plurality of arrays in which a plurality of sixth units different from both the fourth units and the fifth units are arranged in the first direction, and
the fourth region includes a plurality of arrays in which a plurality of the sixth units are arranged in the second direction.

[7] The electromagnetic wave absorbing member according to [5] or [6], wherein the third region and the fourth region are repeatedly arranged at regular spacings.

[8] The electromagnetic wave absorbing member according to any one of [5] to [7], wherein the conductive pattern of the fourth region is a pattern obtained by at least rotating or inverting the conductive pattern of the third region.

[9] The electromagnetic wave absorbing member according to any one of [5] to [8], wherein the first region is arranged so as to be adjacent to at least one of the third region and the fourth region and not to be adjacent to the second region.

[10] The electromagnetic wave absorbing member according to any one of [5] to [8], wherein the first region is arranged so as to be adjacent to at least one of the second region and the fourth region and not to be adjacent to the third region.

[11] The electromagnetic wave absorbing member according to any one of [1] to [10], further comprising a fifth region that has a conductive pattern including a plurality of the first arrays and a plurality of the second arrays, wherein

in the fifth region,
a plurality of the first units and a plurality of the second units are arranged in a third direction different from both the first direction and the second direction, and
the first array and the second array are arranged adjacent to each other.

[12] The electromagnetic wave absorbing member according to any one of [1] to [11], further comprising a spacer layer and a reflective layer.

[Advantageous Effects of Invention]

According to the present invention, an electromagnetic wave absorbing member having stable performance regardless of the polarization direction of incident electromagnetic waves can be provided.

[Brief Description of Drawings]

Fig. 1 is a cross-sectional view of an electromagnetic wave absorbing member according to the present embodiment.

Fig. 2 is a plan view illustrating an example of a conductive pattern of the electromagnetic wave absorbing member according to the present embodiment.

Fig. 3 is a plan view illustrating a conductive pattern of an electromagnetic wave absorbing member to be compared.

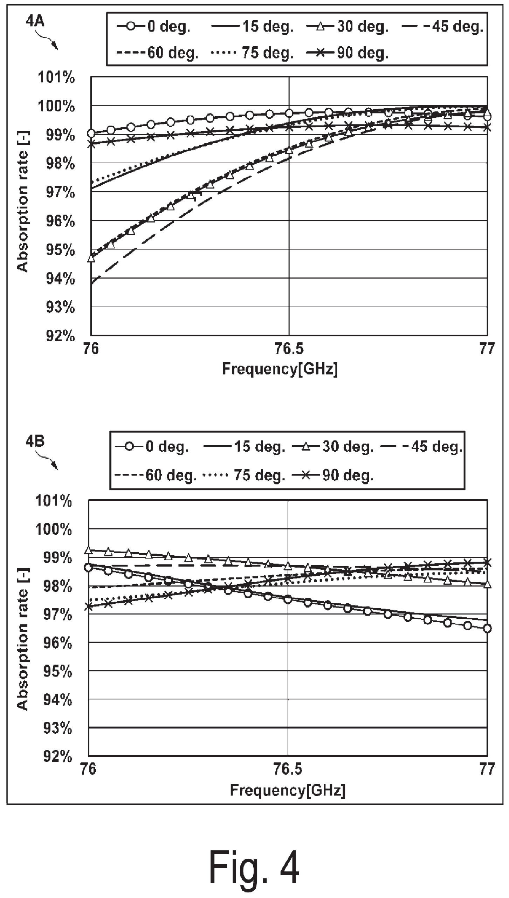

Part 4A of Fig. 4 is a diagram showing the electromagnetic wave absorption characteristics of the electromagnetic wave absorbing member to be compared, and part 4B of Fig. 4 is a diagram showing the electromagnetic wave absorption characteristics of the electromagnetic wave absorbing member according to the first embodiment.

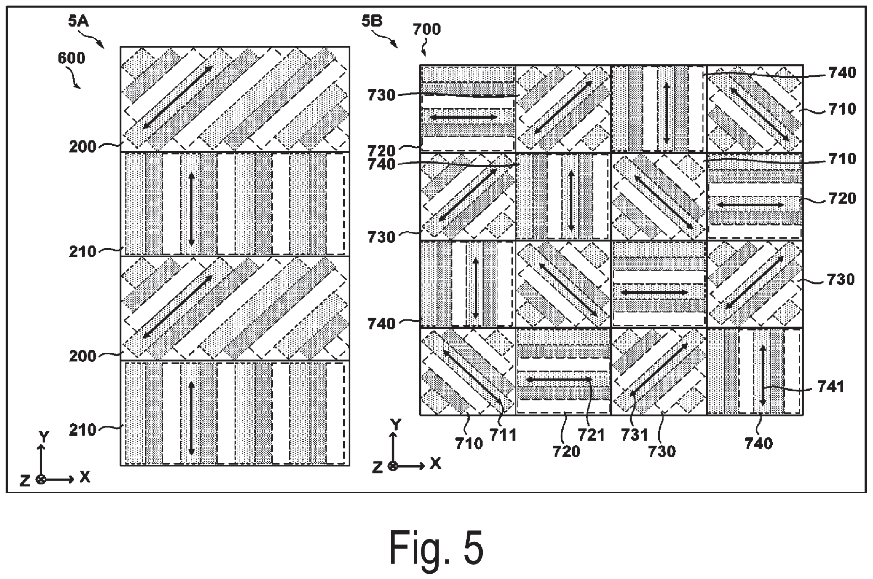

Part 5A of Fig. 5 is a plan view illustrating the first modification of the conductive pattern of the electromagnetic wave absorbing member according to the first embodiment, and part 5B of Fig. 5 is a plan view illustrating a second modification of the conductive pattern of the electromagnetic wave absorbing member according to the first embodiment.

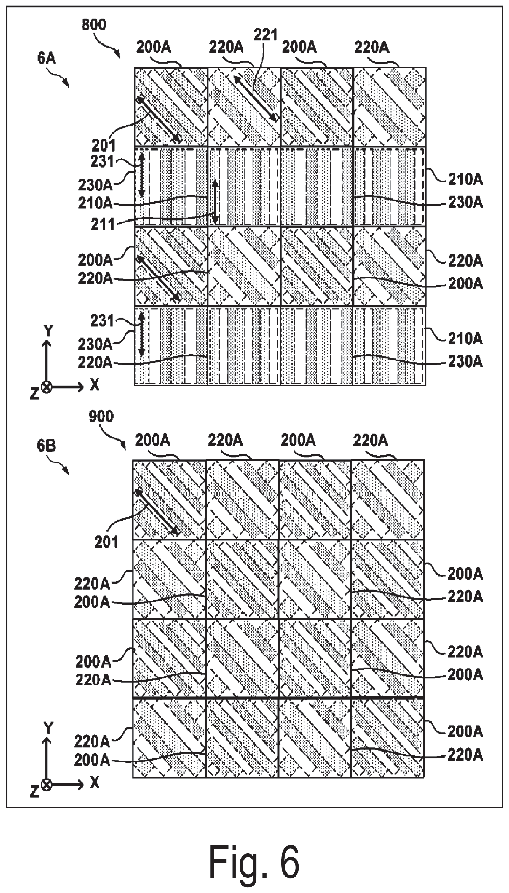

Part 6A of Fig. 6 is a plan view illustrating an example of a conductive pattern of an electromagnetic wave absorbing member according to a second embodiment, and part 6B of Fig. 6 is a plan view illustrating a reference example of the conductive pattern of the electromagnetic wave absorbing member.

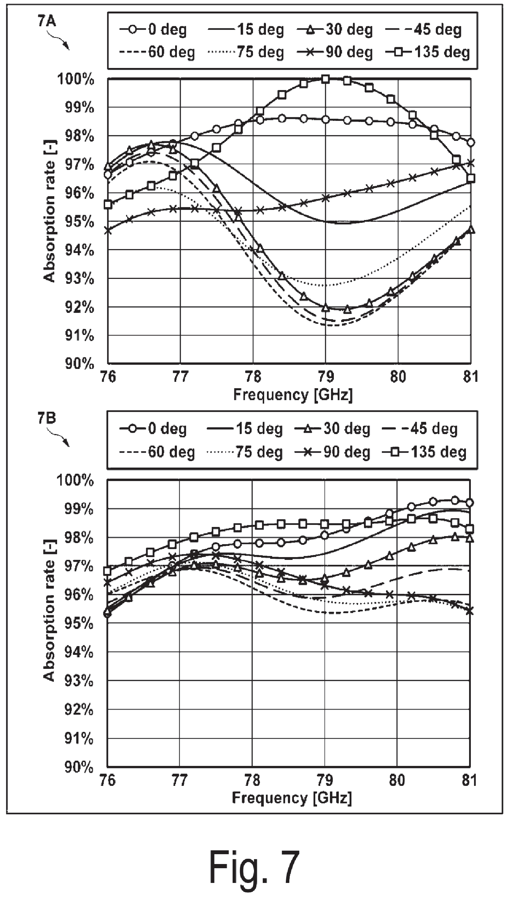

Part 7A of Fig. 7 is a diagram showing the electromagnetic wave absorption characteristics of an electromagnetic wave absorbing member of a reference example, and part 7B of Fig. 7 is a diagram showing the electromagnetic wave absorption characteristics of the electromagnetic wave absorbing member according to the second embodiment.

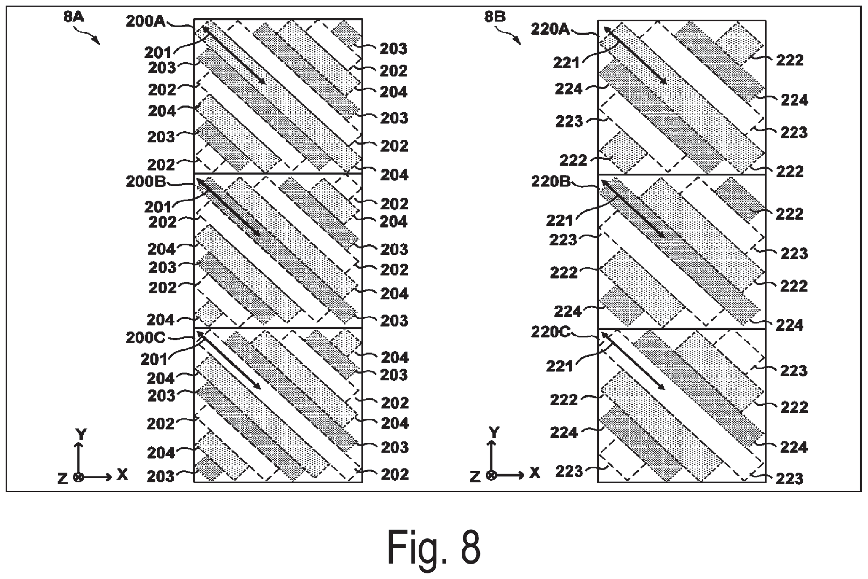

Part 8A of Fig. 8 is a plan view illustrating a modification of one region of the conductive pattern of the electromagnetic wave absorbing member, and part 8B of Fig. 8 is a plan view illustrating a modification of one region of the conductive pattern of the electromagnetic wave absorbing member.

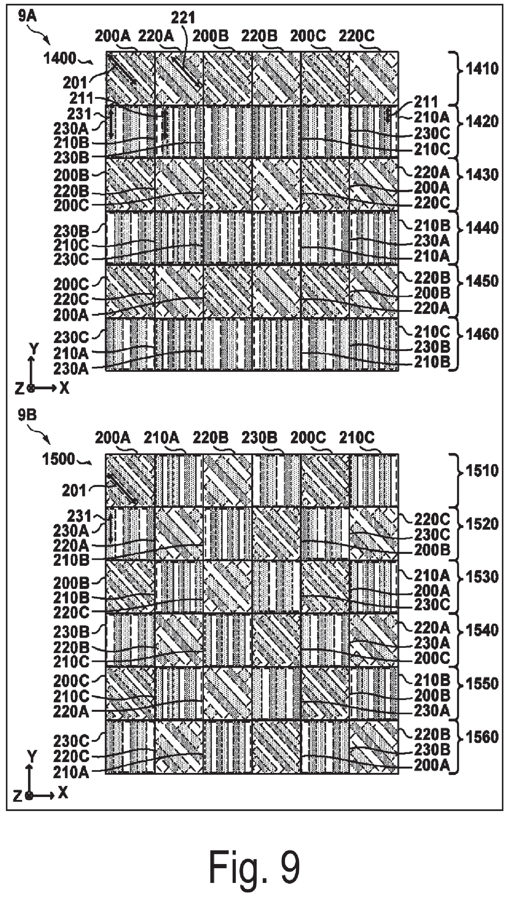

Part 9A of Fig. 9 is a plan view illustrating the first modification of the conductive pattern of the electromagnetic wave absorbing member according to the second embodiment, and part 9B of Fig. 9 is a plan view illustrating the second modification of the conductive pattern of the electromagnetic wave absorbing member according to the second embodiment.

[Description of Embodiments]

Embodiments will be described in detail below with reference to the accompanying drawings. Note that the following embodiments do not limit the invention according to the scope of claims. Although a plurality of features are described in the embodiments, not all of the plurality of features are necessarily essential to the invention, and the plurality of features may be combined as desired. In the accompanying drawings, the same or similar configurations are denoted by the same reference numerals, and redundant description is omitted.

In the present specification, a "conductive pattern" is a collection of units that are geometric figures, and refers to an object that selectively transmits electromagnetic waves of certain frequencies. It may be construed that the "conductive pattern" has a function similar to a so-called antenna. In the present specification, "electromagnetic waves in the millimeter wave region" refers to electromagnetic waves with wavelengths from 1 mm to 10 mm. "Electromagnetic waves in the millimeter wave region" also refers to electromagnetic waves with frequencies from 30 GHz to 300 GHz. In the present specification, "from (a number) to (a number)", which indicates a numerical range, includes the number after "from" as the lower limit of the numerical range and the number after "to" as the upper limit of the numerical range.

<First Embodiment>

Electromagnetic Wave Absorbing Member

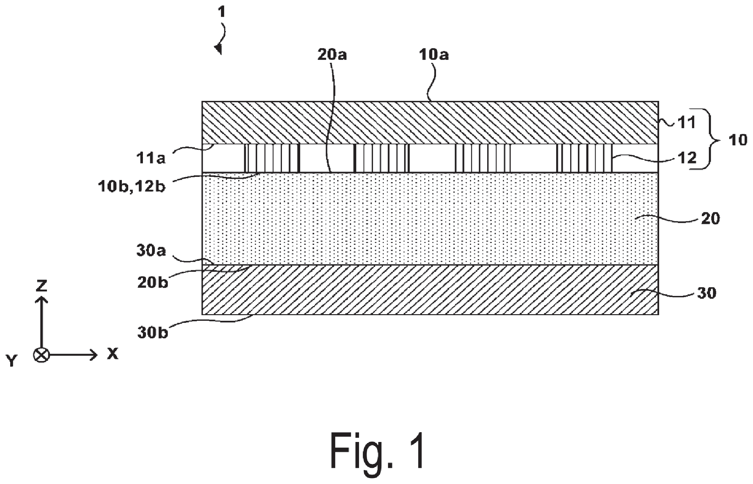

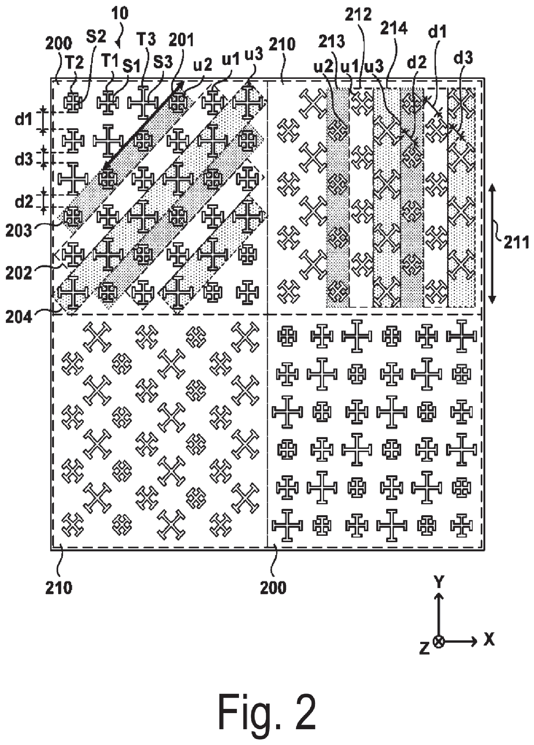

Fig. 1 schematically illustrates an electromagnetic wave absorbing member according to the present embodiment in cross-section along a thickness direction. Fig. 2 is a plan view schematically illustrating an example of a conductive pattern of the electromagnetic wave absorbing member according to the present embodiment. As illustrated in Fig. 1, an electromagnetic wave absorbing member 1 according to the present embodiment includes a resistive layer 10, a spacer layer 20, and a reflective layer 30. The resistive layer 10, the spacer layer 20, and the reflective layer 30 are laminated in this order.

The reflective layer 30 is disposed on another surface (back surface) 10b side of the resistive layer 10. The spacer layer 20 is disposed between the resistive layer 10 and the reflective layer 30. That is, the resistive layer 10 and the reflective layer 30 are laminated with the spacer layer 20 interposed therebetween.

The resistive layer 10 may be a single layer, or may include a base 11 and a conductive pattern 12 formed on the base 11 as illustrated in Fig. 1. When the resistive layer 10 is a single layer, the resistive layer 10 is made of a material similar to the conductive pattern 12 described later.

(Resistive Layer)

The resistive layer 10 consists of a Frequency Selective Surface (FSS). A frequency selective surface is a surface that can block or transmit only electromagnetic waves of specific frequencies by forming a continuous structure having a shape equal to or smaller than a wavelength with a conductive member or the like.

The conductive pattern 12 described later is formed on the resistive layer 10. The conductive pattern 12 is formed by disposing, for example, a thin metal wire, a thin conductive film, a conductive paste deposit, or the like on the base 11. Examples of the metal include copper, aluminum, tungsten, iron, molybdenum, nickel, titanium, silver, gold, and an alloy containing two or more of the metals listed above (for example, steel such as stainless steel and carbon steel, brass, phosphor bronze, zirconium-copper alloy, beryllium-copper, iron-nickel, nichrome, nickel-titanium, kanthal, Hastelloy, and rhenium-tungsten).

Examples of a material of the thin conductive film include metal particles, carbon nanoparticles, and carbon fibers. Note that the conductive pattern 12 may be formed using a plurality of materials in order to adjust the transmission characteristics of the resistive layer 10.

The base 11 is a flat plate-shaped member, and its thickness may be, for example, 5 $\mu$m to 500 $\mu$m, 15 $\mu$m to 200 $\mu$m, or 25 $\mu$m to 100 $\mu$m. A material of the base 11 can be appropriately selected according to the application of the electromagnetic wave absorbing member 1. For example, the base 11 may be made of a transparent material for the purpose of providing transparency to the electromagnetic wave absorbing member 1. Alternatively, the base 11 may be made of a flexible material for the purpose of providing the electromagnetic wave absorbing member 1 with conformability to curved surfaces. A surface of the base 11 may be smoothed for the purpose of improving the transparency and three-dimensional formability of the electromagnetic wave absorbing member 1.

For example, the base 11 can be made of resin. The resin may be a thermoplastic resin or a thermosetting resin. It should be noted that when considering the three-dimensional formability of the electromagnetic wave absorbing member 1, the base 11 preferably contains a thermoplastic resin. Examples of the thermoplastic resin include a polyolefin resin, a polyester resin, a polyester-polyether resin, a polyacrylic resin, a polystyrene resin, a polyimide resin, a polyimide amide resin, a polyamide resin, a polyurethane resin, a polycarbonate resin, a polyarylate resin, a melamine resin, an epoxy resin, a urethane resin, a silicone resin, and a fluororesin. Specific examples of the polyolefin resin include polypropylene and polyethylene. Specific examples of the polyester resin include polyethylene terephthalate, polybutylene terephthalate, and polyethylene naphthalate.

The base 11 may contain an optional component provided as long as the effects of the present embodiment are not impaired. Examples of the optional component include, for example, an inorganic filler, a colorant, a curing agent, an antioxidant, a photostabilizer, a flame retardant, a conductive agent, an antistatic agent, and a plasticizer.

The thickness, permittivity, electrical conductivity, and magnetic permeability of the base 11 can be set as appropriate considering further improvement in the electromagnetic wave absorption performance of the electromagnetic wave absorbing member 1. When considering the electrical properties of electromagnetic waves to be absorbed, the base 11 may be a high-permittivity layer. When the base 11 is a high-permittivity layer, a thickness of the electromagnetic wave absorbing member 1 can be relatively thin.

The resistive layer 10 can be produced by, for example, the following method. First, the base 11 is prepared. Next, a conductive pattern described later is formed on one surface 11a of the base 11. Each of the conductive patterns is formed such that a value of a frequency, at which a transmission amount of electromagnetic waves transmitted through each of the conductive patterns exhibits its local maximum value, is a predetermined value [GHz]. The order in which the conductive patterns are formed is not particularly limited. The conductive patterns may be formed in the same process or may be formed in separate processes.

A method for forming each of the conductive patterns is not particularly limited, as long as the method allows absorption of a predetermined frequency with the configuration of the electromagnetic wave absorbing member. Examples of the method for forming each of the conductive patterns include the following methods. (1) A printing method of printing each conductive pattern on the one surface 11a of the base 11 using a conductive paste, (2) a developing method of developing each conductive pattern on the one surface 11a of the base 11, (3) a method of providing a metallic thin film on the one surface 11a of the base 11 by a sputtering method, vacuum vapor deposition, or lamination of metallic foils and forming a pattern of the metallic thin film on the one surface 11a of the base 11 by photolithography, and (4) a method of disposing a metallic wire on the one surface 11a of the base 11.

(Spacer Layer)

The spacer layer 20 is provided on the other surface 10b of the resistive layer 10. The spacer layer 20 has two surfaces, 20a and 20b. The one surface 20a of the spacer layer 20 faces the other surface 10b of the resistive layer 10. The reflective layer 30 is provided on the other surface 20b of the spacer layer 20. The spacer layer 20 may have a single-layer structure or a multi-layer structure.

The material of the spacer layer 20 can be appropriately selected depending on the application, and examples thereof include a plastic film, paper, cloth, nonwoven fabric, a rubber sheet, and a foam sheet. Among these, a foam sheet is preferable from the viewpoint of easily achieving weight reduction while increasing the thickness. Examples of the foam sheet include a foam sheet obtained by foaming the resin constituting the plastic film and forming the resin into a sheet. Specific examples of the foam sheet include polyethylene foam, polypropylene foam, and polyurethane foam.

When considering a wavelength shortening effect of the spacer layer 20, the thickness of the spacer layer 20 is appropriately changed according to the wavelength of the electromagnetic waves to be absorbed and the relative permittivity of the spacer layer 20. When considering the wavelength shortening effect of the spacer layer 20, the thickness of the spacer layer 20 preferably satisfies the following Equation (1).

$$(\text{Thickness of spacer layer 20 in z-axis direction}) = (\lambda) \times (1/4)/(\varepsilon)^{1/2} ... \text{Equation (1)}$$

Here, $\lambda$ is a wavelength of incoming electromagnetic waves, and $\varepsilon$ is a relative permittivity of the spacer layer 20. The thickness of the spacer layer 20 may be adjusted as appropriate to adjust the absorption characteristics of the electromagnetic wave absorbing member 1. For example, the thickness of the spacer layer 20 can be changed in a range of 0.1 times to 3.0 times the thickness of the spacer layer 20 calculated from the above Equation (1).

When the relationship between the thickness of the spacer layer 20 and the wavelength $\lambda$ satisfies the above Equation (1), the electromagnetic wave absorbing member 1 has a so-called $\lambda/4$ structure. In this case, the phase of the electromagnetic waves that pass through the spacer layer 20 and are reflected by the reflective layer 30 and the phase of the electromagnetic waves that are reflected by the resistive layer 10 are inverted with respect to each other, that is, the phase difference is 180 degrees. As a result, the power of the electromagnetic waves reflected from the electromagnetic wave absorbing member 1 can be reduced. The thickness of the spacer layer 20 can be appropriately set according to the wavelength $\lambda$ of the electromagnetic waves to be absorbed by the electromagnetic wave absorbing member 1. The thickness of the spacer layer 20 may be, for example, 25 $\mu$m to 5000 $\mu$m, 300 $\mu$m to 4000 $\mu$m, or 1000 $\mu$m to 3000 $\mu$m. The spacer layer 20 may be made of a high permittivity material. When the spacer layer 20 is a high permittivity layer, the thickness of the spacer layer 20 can be relatively thin. When considering the permittivity of the spacer layer 20, the spacer layer 20 may contain at least one selected from the group consisting of barium titanate, titanium oxide, and strontium titanate.

(Reflective Layer)

The reflective layer 30 has two surfaces 30a and 30b. The one surface 30a of the reflective layer 30 faces the other surface 20b of the spacer layer 20. The reflective layer 30 is not particularly limited as long as the reflective layer 30 is in a form capable of reflecting electromagnetic waves that arrive at the surface of the electromagnetic wave absorbing member 1 and pass through the electromagnetic wave absorbing member 1. Some of the electromagnetic waves that arrive at the electromagnetic wave absorbing member 1 are reflected by the resistive layer 10 or absorbed by the resistive layer 10. Meanwhile, electromagnetic waves that are neither reflected nor absorbed by the resistive layer 10 pass through the resistive layer 10. The electromagnetic waves that have passed through the resistive layer 10 are reflected by the reflective layer 30 toward the resistive layer 10.

For example, when the reflective layer 30 is electrically conductive in a surface direction of either of the two surfaces 30a and 30b, the reflective layer 30 can reflect the electromagnetic waves that have passed through the resistive layer 10. To be specific, metal foil such as aluminum foil or copper foil, or a metal plate such as a copper plate, can be laminated to a resin film such as a polyethylene terephthalate film to be used as the reflective layer 30. Instead of the metal foil or the metal plate, a transparent conductive film such as an ITO film, or a mesh sheet formed of a metal wire can be used.

When the spacer layer 20 is formed on an object having electrical conductivity, such as a metal, the object having electrical conductivity, such as a metal, serves as the reflective layer 30, and therefore the reflective layer 30 can be omitted.

For the purpose of application of the electromagnetic wave absorbing member 1 to surfaces of various articles, an adhesive layer may be provided on the other surface 30b of the reflective layer 30. When an adhesive layer is provided on the other surface 30b of the reflective layer 30, a release film may be provided on a surface of the adhesive layer opposite to the surface in contact with the surface 30b. The release film is removed when the electromagnetic wave absorbing member 1 is in use. When the release film covers the adhesive surface, handling during distribution becomes easier.

Examples of the adhesive constituting the adhesive layer include a heat seal type adhesive that is activated by heat; an adhesive that is activated by moisture; and a pressure-sensitive adhesive that is activated by pressure. Among these, from the viewpoint of convenience, a pressure-sensitive adhesive may be selected. Specific examples of the pressure-sensitive adhesive include an acrylic-based pressure-sensitive adhesive, a urethane-based pressure-sensitive adhesive, a rubber-based pressure-sensitive adhesive, a polyester-based pressure-sensitive adhesive, a silicone-based pressure-sensitive adhesive, and a polyvinyl ether-based pressure-sensitive adhesive. Among these, at least one selected from the group consisting of an acrylic-based pressure-sensitive adhesive, a urethane-based pressure-sensitive adhesive, and a rubber-based pressure-sensitive adhesive may be used.

The electromagnetic wave absorbing member 1 according to the present embodiment may also include a protective layer formed on one surface (front surface) 10a of the resistive layer 10. The protective layer is not particularly limited as long as it is in a form capable of protecting the resistive layer 10.

Conductive Pattern

Next, details of the conductive pattern 12 will be described with reference to Fig. 2. Fig. 2 is a plan view schematically illustrating the resistive layer 10. The conductive pattern 12 includes a first region 200 and a second region 210. As illustrated in Fig. 2, the first regions 200 and the second regions 210 are repeatedly arranged at regular spacings in both the X direction and the Y direction to form the conductive pattern 12. Note that the spacings in the X direction and the Y direction may be the same or may be different. Note that the regions 200 and 210 are described as being quadrangular, but the regions are not limited to this, and may have any shape such as a triangle or a hexagon.

Note that the electromagnetic wave transmission characteristics represent the ratio (electromagnetic wave transmittance) of the intensity of electromagnetic waves transmitted from the surface 10b of the resistive layer 10 when electromagnetic waves of a predetermined intensity are incident on the surface 10a thereof. In an example, in the electromagnetic wave transmission characteristics, the frequency of the electromagnetic waves and the electromagnetic wave transmittance are associated with each other for a plurality of different frequencies. In addition, in an example, in the electromagnetic wave transmission characteristics, the polarization direction of incident electromagnetic waves, the frequency of the electromagnetic waves, and the electromagnetic wave transmittance are associated with each other. The electromagnetic wave transmission characteristics may be defined for the entire resistive layer 10, or may be defined for each of the first region 200 and the second region 210. In addition, the electromagnetic wave transmission characteristics may be defined for each of a first unit u1 to a third unit u3 of the conductive pattern 12 described below or each of a first array 202 to a third array 204 in which a plurality of the units are arranged.

The first region 200 includes a first array 202 in which a plurality of first units u1 are arranged, a second array 203 in which a plurality of second units u2 are arranged, and a third array 204 in which a plurality of third units u3 are arranged. As illustrated in Fig. 2, each of the first regions 200 includes a plurality of first to third arrays 202 to 204.

In the first region 200, the first to third arrays 202 to 204 extend in a first direction indicated by an arrow 201 (hereinafter sometimes referred to as a direction 201), that is, "units", which are geometric figures included in the arrays, are repeatedly arranged at a predetermined spacing in the first direction.

The second region 210 includes a first array 212 in which a plurality of first units u1 are arranged, a second array 213 in which a plurality of second units u2 are arranged, and a third array 214 in which a plurality of third units u3 are arranged.

In the second region 210, the first to third arrays 212 to 214 extend in a second direction indicated by an arrow 211 (hereinafter sometimes referred to as a direction 211), that is, in the second region 210, units are repeatedly arranged at a predetermined spacing in the second direction 211.

Note that the spacing between units in the array is not particularly limited. The spacing between units may be regular or irregular. The spacing between the plurality of arrays is not particularly limited. The spacing between the plurality of arrays may be regular or irregular. In the present embodiment, the spacing between units is the same value in the first region 200 and the second region 210. Accordingly, after the arrangement spacings of the units u1 to u3 arranged in the first to third arrays 202 to 204 of the first region 200 are determined, the arrangement of the conductors of the second region 210 can be determined by rotating the first region 200 in the XY plane. In another example, after the arrangement of the units of the first region 200 is determined, the arrangement of the units of the second region 210 may be determined by inverting the arrangement of the first region 200 in a predetermined direction on the XY plane illustrated in Fig. 2. In this manner, after the arrangement of the units in the first region 200 is determined, the arrangement of the units in the second region 210 is determined by at least rotating or inverting the arrangement of the units in the first region 200, and thus the arrangement of the units in the second region 210 can be easily designed.

However, the unit arrangement pattern may be designed separately for the first region 200 and the second region 210. In addition, in the vicinity of the boundary between the first region 200 and the second region 210, the impedance may be changed by bonding of the units. Therefore, the spacings between units adjacent to the boundary between the first region 200 and the second region 210 may be changed from d1 to d3 in Fig. 2.

(First Array)

As described above, the first arrays 202 and 212 are each constituted by a plurality of first units u1. Each of the first units u1 is a geometric figure.

That is, it may be construed that the first arrays 202 and 212 are a collection of the first units u1 that are geometric figures. Each of the first units u1 functions as a single antenna. The first arrays 202 and 212 may be, for example, a fine line pattern of an FSS element.

As illustrated in Fig. 2, a shape of the first unit u1 is a cross shape with vertical and horizontal symmetry. Specifically, the first unit u1 has one cross portion S1 and four end portions T1. The cross portion S1 includes two linear portions orthogonal to each other, and the two linear portions are arranged to intersect at 45 degrees and -45 degrees with respect to the direction in which the unit u1 is arranged. The end portions T1 having a linear shape are each in contact with each end of the two linear portions included in the cross portion S1, such that they are orthogonal to each linear portion.

By adjusting the length and width of the linear portions of the cross portion S1 of the first unit u1 and the length and width of each of the four end portions T1, electromagnetic wave transmission characteristics of the first unit u1 that functions as a single antenna can be adjusted.

It should be noted that the shape of the first unit u1 is not limited to a cross shape. The shape of the first unit u1 is not particularly limited, as long as the value of a frequency, at which a transmission amount of electromagnetic waves transmitted through the first arrays 202 and 212 exhibits its local maximum value, is to be A [GHz]. Examples of the shape of a figure for the first unit u1 include a circular shape, an annular shape, a linear shape, a rectangular shape, a polygonal shape, an H shape, a Y shape, and a V shape.

In the present embodiment, the description will be given assuming that the shapes of the plurality of first units u1 included in one array are the same. It should be noted that the shapes of the plurality of first units u1 do not need to be the same. In other examples, the shapes of the plurality of first units u1 may be the same or different from each other, as long as the transmission characteristics can be adjusted to a target frequency.

The first arrays 202 and 212 selectively transmit electromagnetic waves with a frequency of A [GHz]. The frequency value A [GHz] is a value of a frequency at which a transmission amount of electromagnetic waves transmitted through the first arrays 202 and 212 exhibits its local maximum value in a range from 20 GHz to 110 GHz.

The first arrays 202 and 212 transmit electromagnetic waves having a frequency of A [GHz] as determined by method X above.

For the resistive layer 10 according to the present embodiment, the frequency value A is from 20 GHz to 110 GHz, for example, preferably from 60 GHz to 100 GHz, more preferably from 65 GHz to 95 GHz, and is from 70 GHz to 90 GHz, for example. When the frequency value A is within the numerical range mentioned above, the resistive layer 10 can transmit electromagnetic waves in the millimeter wave region, and thus the resistive layer 10 can be readily applied to automobile components, road peripheral members, building exterior wall related materials, windows, communication devices, radio telescopes, and the like.

The spacings between ends of the figures that are the first units u1 are not particularly limited as long as the transmission characteristics can be adjusted to a desired frequency. For example, the spacings between ends of the figures that are the first units u1 may all be identical to or may be different from each other. It should be noted that from the viewpoint of easily designing the resistive layer 10 that is less susceptible to the surrounding environment and, during production, improving precision of the frequency band of electromagnetic waves to be transmitted, the spacings between ends of the figures that are the first units u1 are preferably identical to each other.

(Second Array)

As illustrated in Fig. 2, the second arrays 203 and 213 are each constituted by a plurality of second units u2. A shape of the second unit u2 is a cross shape with vertical and horizontal symmetry as in the case of the first unit u1. Specifically, the second unit u2 has one cross portion S2 and four end portions T2, and either the dimension of S2 or T2 is different from the dimension of the first unit u1.

The dimensions of S2 and T2 in the second arrays 203 and 213 are designed so as to selectively transmit electromagnetic waves having a frequency of B [GHz] satisfying the following Equation (2). The frequency value B [GHz] is a value of a frequency at which a transmission amount of electromagnetic waves transmitted through the second arrays 203 and 213 exhibits its local maximum value. The frequency value B [GHz] satisfies the following Equation (2).

$$1.037 \times A \leq B \leq 1.30 \times A ... \text{Equation (2)}$$

As shown in the above Equation (2), the second arrays 203 and 213 transmit electromagnetic waves with frequencies from $1.037 \times A$ [GHz] to $1.30 \times A$ [GHz]. The second arrays 203 and 213 preferably transmit electromagnetic waves with frequencies from $1.17 \times A$ [GHz] to $1.25 \times A$ [GHz].

Because the second arrays 203 and 213 transmit electromagnetic waves of a frequency of $1.037 \times A$ [GHz] or higher, the peak of a transmission amount of electromagnetic waves transmitted by the second arrays 203 and 213 and the peak of a transmission amount of electromagnetic waves transmitted by the first arrays 202 and 212 sufficiently overlap in a frequency band higher than A [GHz]. As a result, compared to an electromagnetic wave absorbing member having the first arrays 202 and 212 alone, the frequency band of electromagnetic waves that can be absorbed by the entire electromagnetic wave absorbing member is extended to a frequency band higher than A [GHz]. That is, the frequency band of electromagnetic waves that can be absorbed by the entire electromagnetic wave absorbing member can be widened to the high frequency side.

Because the second arrays 203 and 213 transmit electromagnetic waves of a frequency of $1.30 \times A$ [GHz] or lower, a difference in frequency between the peak of a transmission amount of electromagnetic waves transmitted by the second arrays 203 and 213 and the peak of a transmission amount of electromagnetic waves transmitted by the first arrays 202 and 212 in a frequency band higher than A [GHz] is reduced. As a result, a single peak at which an absorption amount of electromagnetic waves absorbed by the entire electromagnetic wave absorbing member 1 reaches its local maximum value is formed. As described above, the second arrays 203 and 213 transmit electromagnetic waves with frequencies from $1.037 \times A$ [GHz] to $1.30 \times A$ [GHz], and thus an absorption amount of electromagnetic waves absorbed by the entire electromagnetic wave absorbing member is extended to a higher frequency band.

A material of the second units u2 constituting the second arrays 203 and 213 is not particularly limited, as long as the material can transmit electromagnetic waves of B [GHz] and the transmission characteristics can be adjusted to the desired frequency.

(Third Array)

As illustrated in Fig. 2, the third arrays 204 and 214 are each constituted by a plurality of the third units u3.

A shape of the third unit u3 is a cross shape with vertical and horizontal symmetry as in the case of the first unit u1. Specifically, the third unit u3 has one cross portion S3 and four end portions T3, and either the dimension of S3 or T3 is different from the dimensions of the first unit u1 and the second unit u2.

The dimensions of S3 and T3 in the third arrays 204 and 214 are designed so as to selectively transmit electromagnetic waves having a frequency of C [GHz] satisfying the following Equation (3). The frequency value C [GHz] is a value of a frequency at which a transmission amount of electromagnetic waves transmitted through the third arrays 204 and 214 exhibits its local maximum value. The frequency value C [GHz] satisfies the following Equation (3).

$$0.60 \times A \leq C \leq 0.963 \times A ... \text{Equation (3)}$$

As shown in the above Equation (3), the third arrays 204 and 214 transmit electromagnetic waves with frequencies from $0.60 \times A$ [GHz] to $0.963 \times A$ [GHz]. The third arrays 204 and 214 preferably transmit electromagnetic waves with frequencies from $0.60 \times A$ [GHz] to $0.83 \times A$ [GHz].

Because the third arrays 204 and 214 transmit electromagnetic waves of a frequency of $0.60 \times A$ [GHz] or higher, a difference in frequency between the peak of a transmission amount of electromagnetic waves transmitted by the third arrays 204 and 214 and the peak of a transmission amount of electromagnetic waves transmitted by the first arrays 202 and 212 in a frequency band lower than A [GHz] is reduced. As a result, a single peak at which a transmission amount of electromagnetic waves transmitted through the entire resistive layer 10 reaches its local maximum value is formed.

Because the third arrays 204 and 214 transmit electromagnetic waves of a frequency of $0.963 \times A$ [GHz] or lower, the peak of a transmission amount of electromagnetic waves transmitted by the third arrays 204 and 214 and the peak of a transmission amount of electromagnetic waves transmitted by the first arrays 202 and 212 sufficiently overlap in a frequency band lower than A [GHz]. As a result, compared to a film having the first arrays 202 and 212 alone, the frequency band of electromagnetic waves that can be absorbed by the electromagnetic wave absorbing member is extended to a frequency band lower than A [GHz]. That is, the frequency band of electromagnetic waves that can be absorbed by the entire electromagnetic wave absorbing member can be widened to the low frequency side.

As described above, the third arrays 204 and 214 transmit electromagnetic waves with frequencies from $0.60 \times A$ [GHz] to $0.963 \times A$ [GHz], and thus a transmission amount of electromagnetic waves transmitted through the entire resistive layer 10 is extended to a lower frequency band.

A material of the third units u3 constituting the third arrays 204 and 214 is not particularly limited, as long as the material can transmit electromagnetic waves of C [GHz] and the transmission characteristics can be adjusted to the desired frequency.

In Fig. 2, in both the first region 200 and the second region 210, the first arrays 202 and 212, the second arrays 203 and 213, and the third arrays 204 and 214 are arranged so as to be adjacent to each other. As described above, the first arrays 202 and 212, the second arrays 203 and 213, and the third arrays 204 and 214 are arranged adjacent to each other on the base 11, and thus the frequency band of electromagnetic waves selectively transmitted by the second arrays 203 and 213 and the frequency band of electromagnetic waves selectively transmitted by the third arrays 204 and 214 overlap with reference to the frequency value A [GHz] of the peak position of electromagnetic waves selectively transmitted by the first arrays 202 and 212. As a result, the transmission band of electromagnetic waves transmitted through the entire resistive layer 10 can be easily extended to both the higher frequency side and the lower frequency side based on the frequency value A [GHz] at the peak position.

A spacing d1 between the first unit u1 and the second unit u2, a spacing d2 between the second unit u2 and the third unit u3, a spacing d3 between the third unit u3 and the first unit u1, each as illustrated in Fig. 2, may be identical to or different from each other. The spacing d1 may be, for example, from 0.2 mm to 4 mm, from 0.3 mm to 2 mm, or from 0.5 mm to 1 mm. The spacing d2 may be, for example, from 0.2 mm to 4 mm, from 0.3 mm to 2 mm, or from 0.5 mm to 1 mm. The spacing d3 may be, for example, from 0.2 mm to 4 mm, from 0.3 mm to 2 mm, or from 0.5 mm to 1 mm. When the spacing d1, the spacing d2, and the spacing d3 are within the above numerical ranges, the transmission band of electromagnetic waves transmitted through the entire resistive layer 10 can be more easily extended with reference to the frequency value A [GHz] at the peak position. Note that as described above, the values of d1 to d3 may be different between the first region 200 and the second region 210.

In the resistive layer 10, shapes of the first unit u1, the second unit u2, and the third unit u3 are identical to each other. It should be noted that the shapes of the first unit u1, the second unit u2, and the third unit u3 do not need to be identical to each other. That is, in other examples of the present invention, the shapes of the first unit u1, the second unit u2, and the third unit u3 may be identical to or different from each other. In addition, in the example of Fig. 2, the first unit u1, the second unit u2, and the third unit u3 are illustrated as having the same orientation, but of the first unit u1, the second unit u2, and the third unit u3, two adjacent units may have different orientations.

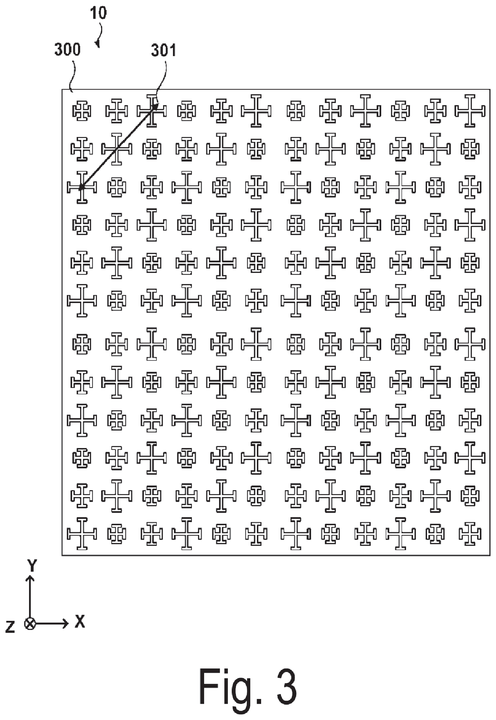

Here, Fig. 3 illustrates a conductive pattern 300 of an electromagnetic wave absorbing member constituted by only a single region. In the conductive pattern 300 of the electromagnetic wave absorbing member, the first unit u1, the second unit u2, and the third unit u3 described with reference to Fig. 2 are arranged along a single direction 301.

Part 4A of Fig. 4 shows the absorption characteristics of the electromagnetic wave absorbing member 1 including the conductive pattern 300 to be compared. When electromagnetic waves are incident in a direction perpendicular to the incident surface of the electromagnetic wave absorbing member 1, that is, in the Z direction, the absorption rate is calculated as $Ra = 1-P_{ref}/P_{in}$, where the incident signal intensity is $P_{in}$, the reflected signal intensity is $P_{ref}$, and the absorption rate is Ra. In addition, the polarization direction of the incident electromagnetic waves is calculated as 0 degrees (0 deg) in the case of vertical polarization, that is, when the direction of oscillation of the electric field is the Y direction, and Ra is measured by rotating the inclination of the vibration direction of the electric field with respect to the Y axis in Fig. 3 in increments of 15 degrees. For example, the polarization direction of the incident electromagnetic waves is calculated as 90 degrees (90 deg) in the case of horizontal polarization, that is, when the direction of oscillation of the electric field is the X direction.

When the polarization direction is 30 degrees, 45 degrees, and 60 degrees, the absorption rate may be lower than 96% between 76 GHz and 76.2 GHz as illustrated in part 4A of Fig. 4. It is also understood that the absorption rate varies by about 5% at the maximum depending on the polarization direction.

The results of measuring the absorption rate of the electromagnetic wave absorbing member 1 illustrated in Fig. 2 are shown in part 4B of Fig. 4. Note that the polarization direction of the electromagnetic waves is the same as that in part 4A of Fig. 4. It is found that, as shown in part 4B of Fig. 4, the electromagnetic wave absorbing member 1 according to the present embodiment has an absorption rate of more than 96% in any polarization direction. It is also understood that the difference in absorption rate due to the difference in the polarization direction is suppressed to about 3%.

As illustrated in part 4A of Fig. 4, the electromagnetic wave absorbing member including the conductive pattern 300 to be compared can have electromagnetic wave absorption characteristics that vary depending on the orientation of the conductive pattern with respect to the polarization direction of incident electromagnetic waves. Therefore, when the electromagnetic wave absorbing member including the conductive pattern 300 to be compared is used, it is necessary to adjust the orientation of the electromagnetic wave absorbing member 1 so that the polarization direction exhibiting high absorption characteristics when the electromagnetic waves are incident on the electromagnetic wave absorbing member and the polarization direction of the electromagnetic waves incident on the electromagnetic wave absorbing member coincide with each other. In addition, when a plurality of high-frequency components having different outgoing polarization directions are inspected, it is necessary to change the orientation of the electromagnetic wave absorbing member for each inspection. As described above, with the electromagnetic wave absorbing member including the conductive pattern 300 to be compared, the electromagnetic wave absorption characteristics may change depending on the polarization direction of the incident electromagnetic waves.

On the other hand, by arranging a plurality of regions 200 and 210 having different characteristics with respect to the polarization direction of the incident electromagnetic waves, the electromagnetic wave absorbing member 1 including the conductive pattern according to the present embodiment can maintain high absorption characteristics even when the polarization direction of the incident electromagnetic waves changes. This makes it possible to use the electromagnetic wave absorbing member 1 without considering the polarization direction of the incident electromagnetic waves, and thus it is possible to improve convenience when the user uses the electromagnetic wave absorbing member.

In the electromagnetic wave absorbing member 1 according to the present embodiment, two or more types of units are arranged side by side in one region. This makes it possible to broaden the frequency band in which the electromagnetic wave absorbing member 1 absorbs electromagnetic waves.

First Modification

In the example of Fig. 2, the first region 200 and the second region 210 are illustrated as being repeatedly arranged at regular spacings in the X direction and the Y direction. However, the arrangement of the first region 200 and the second region 210 may be a different pattern.

Part 5A of Fig. 5 illustrates a conductive pattern 600 of an electromagnetic wave absorbing member according to the first modification. Note that the same reference numerals are used for configurations similar to those in Fig. 2, and the description thereof will be omitted. In the conductive pattern 600 according to the first modification, a first region 200 and a second region 210 are alternately and repeatedly arranged in one direction. That is, as illustrated in Fig. 2, the first region 200 and the second region 210 may be alternately and repeatedly arranged two dimensionally, or as illustrated in part 5A of Fig. 5, the first region 200 and the second region 210 may be alternately and repeatedly arranged one dimensionally.

Second Modification

In the example of Fig. 2, the first region 200 in which conductor units are arranged in the first direction and the second region 210 in which conductor units are arranged in the second direction are illustrated as being repeatedly arranged at regular spacings. In an example, the conductive pattern may additionally include a region in which the conductor units are arranged in a direction different from the first and second directions.

Part 5B of Fig. 5 illustrates a conductive pattern 700 of an electromagnetic wave absorbing member according to the second modification. Note that the same reference numerals are used for configurations similar to those in Fig. 2, and the description thereof will be omitted. The conductive pattern 700 of the electromagnetic wave absorbing member includes a region 710 in which units are arranged in a direction indicated by an arrow 711 (hereinafter referred to as a direction 711), a region 720 in which units are arranged in a direction indicated by an arrow 721 (hereinafter referred to as a direction 721), a region 730 in which units are arranged in a direction indicated by an arrow 731 (hereinafter referred to as a direction 731), and a region 740 in which units are arranged in a direction indicated by an arrow 741 (hereinafter referred to as a direction 741). Note that the regions 710, 720, 730, and 740 have configurations similar to the regions 200 and 210 described with reference to Fig. 2 except that the direction in which the units are arranged is different. In the regions 710, 720, 730, and 740, the directions 711, 721, 731, and 741 in which the units are arranged are different from each other.

Note that in the example of part 5B in Fig. 5, the direction in which the units are arranged is illustrated as being at 45 degree intervals, but the direction is not limited thereto, and may be at 22.5 degree intervals, for example. In addition, in Fig. 2, the units are arranged in two directions, that is, a direction along the arrow 201 and a direction along the arrow 211, and in part 5B of Fig. 5, the units are arranged in four directions, that is, directions 711, 721, 731, and 741. However, it is sufficient for the conductive pattern to have a plurality of directions in which the units are arranged, and the units may be arranged in three directions or in five or more directions.

Furthermore, as described with reference to Fig. 2, the arrangement of the units in the regions 710 to 740 may be individually determined, or may be determined by at least rotating or inverting the arrangement of the units in one region.

<Second Embodiment>

As illustrated in part 6A of Fig. 6, an electromagnetic wave absorbing member 1 according to the second embodiment includes a conductive pattern 800 including a first region 200A, a second region 210A, a third region 220A, and a fourth region 230A (hereinafter sometimes referred to as regions 200A to 230A without distinction). Note that the description of configurations similar to those in the first embodiment will be omitted.

The first region 200A has a configuration similar to that of the region 200 described with reference to Fig. 2, and includes first to third arrays 202 to 204 in which units u1 to u3 are arranged in the first direction 201.

The second region 210A has a configuration similar to that of the second region 210 described with reference to Fig. 2. The second region 210A has units u1 to u3 similar to those of the first region 200A, but is different from the first region 200A in that the units u1 to u3 are arranged along a third direction 211 different from the first direction 201. However, in the second region 210A, in addition to the direction in which the units are arranged, at least one of the shape, any dimension, and the spacing of the units u1 to u3, and the spacing between the arrays may be changed as compared with the first region 200A.

The third region 220A is different from the adjacent first region 200A in at least one of the shape, any dimension, and the spacing of the first to third units u1 to u3, and the spacing between the arrays. Accordingly, the regions 200A and 220A have different electromagnetic wave transmission characteristics. Note that in the present embodiment, the first direction 201 in which the units are arranged in the first region 200A and the second direction 211 in which the units are arranged in the third region 220A are described as being the same, but the first direction 201 and the second direction 211 may be different from each other, as a matter of course.

For example, when the first region 200A has a plurality of types of units as described above, the third region 220A preferably has the same types of units, and at least one of the surface area, the thickness, and the array spacing of the units is preferably reduced by a predetermined degree. Specifically, the surface area or thickness of each unit of the third region 220A is preferably 99% to 60%, more preferably 95% to 80%, of the first unit u1 to third unit u3 of the first region 200A. The array spacing in the third region 220A is preferably 99% to 60%, and more preferably 90% to 70%, of the array spacing in the first region 200A.

The fourth region 230A has the units u1 to u3 similar to those of the third region 220A, but is different from the third region 220A in that the units u1 to u3 are arranged along a fourth direction 231 different from the third direction 221. However, in the fourth region 230A, in addition to the direction in which the units are arranged, at least one of the shape, any dimension, and the spacing of the units u1 to u3, and the spacing between the arrays may be changed as compared with the third region 220A.

Here, as a reference example, part 6B of Fig. 6 illustrates a conductive pattern 900 of an electromagnetic wave absorbing member including only the first region 200A and the third region 220A. In the conductive pattern 900, the first region 200A and the third region 220A described with reference to part 6A of Fig. 6 are repeatedly and alternately arranged.

Part 7A of Fig. 7 shows the absorption characteristics of the electromagnetic wave absorbing member 1 including the conductive pattern 900 of the reference example. Note that the polarization direction of the electromagnetic waves is the same as that in parts 4A and 4B of Fig. 4. As illustrated in part 7A of Fig. 7, the difference in absorption rate around 79 GHz is 8% or more between the case where the polarization direction of the incident electromagnetic waves is 45 degrees and the case where the polarization direction of the incident electromagnetic waves is 135 degrees. In other words, the absorption rate varies by 8% or more depending on the angle of the conductive pattern 900 with respect to the polarization direction of the incident electromagnetic waves. Furthermore, it is found that, when the polarization direction of the incident electromagnetic waves is 30, 45, 60, and 75 degrees, the absorption rate of the conductive pattern 900 is less than 95% in the range of 78 GHz to 80.5 GHz.

Part 7B of Fig. 7 shows the absorption characteristics of the electromagnetic wave absorbing member 1 including the conductive pattern 800 illustrated in part 6A of Fig. 6. Note that the polarization direction of the electromagnetic waves is the same as that in part 7A of Fig. 7. It is found that the absorption rate of the conductive pattern 800 exceeds 95% in the range of 76 GHz to 81 GHz for any polarization direction of the incident electromagnetic waves as illustrated in part 5A of Fig. 5. It is also found that the variation in the absorption rate due to the angle of the conductive pattern 800 with respect to the polarization direction of the incident electromagnetic waves is suppressed to less than 5%.

As can be seen from the results of parts 7A and 7B of Fig. 7, the electromagnetic wave absorbing member including the conductive pattern 900 of the reference example can have the electromagnetic wave absorption characteristics that vary depending on the orientation of the conductive pattern with respect to the polarization direction of the incident electromagnetic waves. Therefore, when the electromagnetic wave absorbing member including the conductive pattern 900 of the reference example is used, it is necessary to adjust the orientation of the electromagnetic wave absorbing member 1 so that the polarization direction exhibiting high absorption characteristics when the electromagnetic waves are incident on the electromagnetic wave absorbing member and the polarization direction of the electromagnetic waves incident on the electromagnetic wave absorbing member coincide with each other. In addition, when a plurality of high-frequency components having different outgoing polarization directions are inspected, it is necessary to change the orientation of the electromagnetic wave absorbing member for each inspection.

On the other hand, by arranging the plurality of regions 200A, 210A, 220A, and 230A having different characteristics with respect to the polarization direction of the incident electromagnetic waves, the electromagnetic wave absorbing member 1 including the conductive pattern 800 according to the present embodiment can maintain high absorption characteristics even when the polarization direction of the incident electromagnetic waves changes. This makes it possible to use the electromagnetic wave absorbing member 1 without considering the polarization direction of the incident electromagnetic waves, and thus it is possible to improve convenience when the user uses the electromagnetic wave absorbing member 1.

Next, Table 1 shows changes in the electromagnetic wave absorption characteristics in the range of 76 GHz to 81 GHz when the thickness of the spacer layer 20 is changed for the conductive pattern 300 illustrated in Fig. 3, the conductive pattern 900 illustrated in part 6B of Fig. 6, and the conductive pattern 800 illustrated in part 6A of Fig. 6.

[Table 1]

| | Spacer layer thickness [mm] | Maximum absorption rate [%] at 76 GHz to 81 GHz | Minimum absorption rate [%] at 76 GHz to 81 GHz | Minimum value of maximum absorption rate [%] | Minimum value of minimum absorption rate [%] |
|---|---|---|---|---|---|
| Conductive pattern 300 (only region 200) | 1.80 | 87.0 | 68.4 | 87.0 | 68.4 |
| | 2.00 | 99.8 | 95.1 | | |
| | 2.20 | 94.6 | 85.9 | | |
| Conductive pattern 900 (regions 200A and 210A) | 1.80 | 89.4 | 85.1 | 89.4 | 85.1 |
| | 2.00 | 99.9 | 98.9 | | |
| | 2.20 | 92.4 | 88.7 | | |
| Conductive pattern 800 (regions 200A to 230A) | 1.80 | 94.0 | 87.6 | 91.6 | 87.6 |
| | 2.00 | 99.9 | 98.0 | | |
| | 2.20 | 91.6 | 87.6 | | |

As shown in Table 1, with the conductive pattern 300 illustrated in Fig. 3, when the thickness of the spacer layer 20 is 1.8 mm, the maximum absorption rate in the range of 76 GHz to 81 GHz is 87.0%, and when the thickness of the spacer layer 20 is 1.8 mm, the minimum absorption rate in the range of 76 GHz to 81 GHz is 68.4%. With the conductive pattern 900 illustrated in part 6B of Fig. 6, when the thickness of the spacer layer 20 is 1.8 mm, the maximum absorption rate in the range of 76 GHz to 81 GHz is 89.4%, and when the thickness of the spacer layer 20 is 1.8 mm, the minimum absorption rate in the range of 76 GHz to 81 GHz is 85.1%. With the conductive pattern 800 illustrated in part 6A of Fig. 6, when the thickness of the spacer layer 20 is 2.2 mm, the maximum absorption rate in the range of 76 GHz to 81 GHz is 91.6%, and when the thickness of the spacer layer 20 is 1.8 mm, the minimum absorption rate in the range of 76 GHz to 81 GHz is 87.6%. As described above, it is understood that the conductive pattern 800 according to the present embodiment exhibits stable absorption characteristics even when the thickness of the spacer layer varies greatly.

In the electromagnetic wave absorbing member 1 according to the present embodiment, two or more types of units are arranged side by side in one region. This makes it possible to broaden the frequency band in which the electromagnetic wave absorbing member 1 absorbs electromagnetic waves.

First Modification

In the example of part 6A of Fig. 6, the first region 200A and the third region 220A are regions in which at least one of the shape, the dimension, and the spacing of the units u1 to u3 and the spacing between the arrays is different, and the second region 210A and the fourth region 230A each are regions in which the direction in which the arrays are arranged is different from that of the first region 200A and the third region 220A. In an example, three or more types of regions may be arranged, which have the same array direction and are different in at least one of the shape, the dimension, and the spacing of the units u1 to u3 included in the region, and the spacing between the arrays. Hereinafter, a conductive pattern of an electromagnetic wave absorbing member in which three or more types of regions having the same array direction are arranged will be described with reference to Figs. 8 and 9.

Part 8A of Fig. 8 illustrates a partial region of a conductive pattern according to the first modification. The conductive pattern according to the first modification includes regions 200A to 200C. As described with reference to Fig. 2, in the region 200A, units u1 to u3 are arranged along a direction 201. In the regions 200B and 200C, units u1 to u3 similar to those in the region 200A are arranged along the same direction 201, but the arrangement of the arrays 202 to 204 is different from that in the region 200A. For example, in the regions 200A to 200C, the order in which the arrays 202 to 204 are arranged is the same in the direction orthogonal to the direction 201 in which the units are arranged. On the other hand, the longest array in the direction 201 in which the units are arranged is the array 204 in the region 200A, the array 203 in the region 200B, and the array 202 in the region 200C.

As illustrated in part 8B of Fig. 8, the conductive pattern according to the first modification includes regions 220A to 220C. In the region 220A, the units u1 to u3 are arranged along a direction 221. In the regions 220B and 220C, units u1 to u3 similar to those in the region 220A are arranged along the same direction 221, but the arrangement of the arrays 222 to 224 is different from that in the region 220A.

Note that in the examples illustrated in parts 8A and 8B of Fig. 8, the regions 200A to 200C and the regions 220A to 220C are illustrated as being adjacent to each other, but the arrangement of the regions 200A to 200C and the regions 220A to 220C is not limited thereto.

An example of a conductive pattern according to the first modification is illustrated in part 9A of Fig. 9. A conductive pattern 1400 illustrated in part 9A of Fig. 9 includes rows 1410 to 1460 arranged in the Y-axis direction. Note that the rows 1410 to 1460 may be arranged below the row 1460 in the Y-axis direction. That is, a plurality of the rows 1410 to 1460 can be arranged at equal spacings in the Y-axis direction.

In the row 1410, regions 200A, 220A, 200B, 220B, 200C, and 220C described with reference to parts 8A and 8B of Fig. 8 are arranged in the X-axis direction in this order.

In the row 1420, regions 230A, 210B, 230B, 210C, 230C, and 210A are arranged in the X-axis direction in this order. Here, the region 210A is a region in which the direction 201 in which the units are arranged in the region 200A is changed to a direction 211. Similarly, the regions 210B and 210C are regions in which the direction 201 in which the units are arranged in the regions 200B and 200C is changed to the direction 211. Similarly, the regions 230A, 230B, and 230C each are regions in which the direction 221 in which the units are arranged in the regions 220A to 220C is changed to a direction 231.

Note that the regions 210A to 210C may be different from each other in at least any of the shape, the dimension, and the spacing of the units u1 to u3 included in the region, and the spacing between the arrays.

In addition, the regions 230A to 230C may be different from each other in at least any of the shape, the dimension, and the spacing of the units u1 to u3 included in the region, and the spacing between the arrays.

In the row 1430, regions 200B, 220B, 200C, 220C, 200A, and 220A are arranged in the X-axis direction in this order. In the row 1440, regions 230B, 210C, 230C, 210A, 230A, and 220B are arranged in the X-axis direction in this order. In the row 1450, regions 200C, 220C, 200A, 220A, 200B, and 220B are arranged in the X-axis direction in this order. In the row 1460, regions 230C, 210A, 230A, 210B, 230B, and 210C are arranged in the X-axis direction in this order.

As described above, the regions 200A to 200C and 210A to 210C have different electromagnetic wave transmission characteristics from the regions 220A to 220C and 230A to 230C. Therefore, by arranging regions having different electromagnetic wave transmission characteristics adjacent to each other, the overall electromagnetic wave transmission characteristics of the conductive pattern 1400 can be maintained at a favorable level. Furthermore, as illustrated in rows 1410 to 1460, the regions are arranged such that the direction in which the units u1 to u3 are arranged side by side is different between the regions adjacent in the Y direction. This makes it possible to maintain, in the entire conductive pattern 1400, favorable electromagnetic wave absorption characteristics depending on the polarization direction of incident electromagnetic waves.

Second Modification

In the examples of part 6A of Fig. 6 and part 9A of Fig. 9, the description has been given assuming that the direction in which the units u1 to u3 are arranged is the same in two regions adjacent to each other in the X direction. In an example, the regions may be arranged such that the directions in which the units u1 to u3 are arranged are different in regions adjacent in X and Y directions.

A conductive pattern 1500 according to a second modification is illustrated in part 9B of Fig. 9. In part 9B of Fig. 9, regions similar to the regions 200A to 230C of part 9A of Fig. 9 are arranged in a different pattern. The conductive pattern 1500 includes rows 1510 to 1560.

In the row 1510, regions 200A, 210A, 220B, 230B, 200C, and 210C are arranged in the X direction. In the row 1520, regions 230A, 220A, 210B, 200B, 230C, and 220C are arranged in the X direction. In the row 1530, regions 200B, 210B, 220C, 230C, 200A, and 210A are arranged in the X direction. In the row 1540, regions 230B, 220B, 210C, 200C, 230A, and 220A are arranged in the X direction. In the row 1550, regions 200C, 210C, 220A, 230A, 200B, and 210B are arranged in the X direction. In the row 1560, regions 230C, 220C, 210A, 200A, 230B, and 220B are arranged in the X direction.

In this manner, the regions are arranged such that the directions in which the units u1 to u3 are arranged side by side are different between adjacent regions in both the X direction and the Y direction. This makes it possible to maintain favorable electromagnetic wave absorption characteristics depending on the polarization direction of incident electromagnetic waves in the entire conductive pattern 1500. In addition, by arranging regions having different electromagnetic wave transmission characteristics for every two regions in the X direction and for every one region in the Y direction, the overall electromagnetic wave transmission characteristics of the conductive pattern 1500 can be maintained at a favorable level.

Note that as long as the regions are arranged so that the directions in which the units are arranged are different between the regions adjacent in the X and Y directions, the arrangement pattern of the regions is not limited to the above.

Other Embodiments

The invention is not limited to the above embodiments, and various modifications and changes can be made within the scope of the gist of the invention.

In the examples of Figs. 2 and 5, part 6A of Fig. 6, and Fig. 9, the description has been given assuming that the first to third units are arranged in one region. In an example, two units may be arranged in one region, or four or more types of units may be arranged. That is, the electromagnetic wave absorbing member may have two or more regions including a first region including one or more first arrays in which first units are arranged in a first direction and one or more second arrays in which second units different from the first units are arranged in the first direction, and a second region including one or more third arrays and one or more fourth arrays in which the first and second units are arranged in a second direction different from the first direction, and the number of arrays and the number of regions can be changed as appropriate.

In the present embodiment, a region has been described as being rectangular. However, the shape of the region may be a quadrilateral shape including a parallelogram, a triangular shape, a hexagonal shape, or a polygonal shape, and is not limited to a rectangular shape.

In the examples of Figs. 2 and 5, part 6A of Fig. 6, and Fig. 9, two arrays are illustrated as being arranged so as not to overlap in the direction in which the units are arranged. However, a plurality of arrays may be arranged so as to overlap in the direction in which the units are arranged. For example, after three units u1 are arranged in the direction along the arrow 201, an array in which three units u2 are arranged may be subsequently arranged.

In part 6A of Fig. 6, the description has been given assuming that there are two types of directions in which the units are arranged. However, the units may be arranged in three or more directions. For example, the region may be designed so that units are arranged in four directions, such as 0 degrees, 30 degrees, 60 degrees, and 90 degrees.

[Reference Signs List]

1 Electromagnetic wave absorbing member
10 Resistive layer
11 Base
12 Conductive pattern
20 Spacer layer
30 Reflective layer
200 First region
250 Second region
210, 260 First array
220, 270 Second array
230, 280 Third array

**Claims**

1.   An electromagnetic wave absorbing member comprising a resistive layer including a conductive pattern, wherein:

the resistive layer includes a first region and a second region having different electromagnetic wave transmission characteristics;
the first region has a conductive pattern including
a plurality of first arrays in which a plurality of first units are arranged, and
a plurality of second arrays in which a plurality of second units different from the first units are arranged;
the second region has a conductive pattern including
a plurality of the first arrays, and
a plurality of the second arrays;
a plurality of the first units and a plurality of the second units are arranged in a first direction in the first region;
a plurality of the first units and a plurality of the second units are arranged in a second direction different from the first direction in the second region; and
the first array and the second array are arranged adjacent to each other in the first region and the second region.

2.   The electromagnetic wave absorbing member according to claim 1, wherein:

the first region includes a plurality of third arrays in which a plurality of third units different from both the first unit and the second unit are arranged;

the second region includes a plurality of the third arrays;

the third units are arranged in the first direction in the first region; and

the third units are arranged in the second direction in the second region.

3. The electromagnetic wave absorbing member according to claim 1 or 2, wherein the conductive pattern of the second region is a pattern obtained by at least rotating or inverting the conductive pattern of the first region.

4. The electromagnetic wave absorbing member according to any one of claims 1 to 3, wherein the first region and the second region are repeatedly arranged at regular spacings.

5. The electromagnetic wave absorbing member according to any one of claims 1 to 4, wherein:

the resistive layer further includes a third region and a fourth region having different electromagnetic wave transmission characteristics;

the third region has a conductive pattern including

a plurality of arrays in which a plurality of fourth units are arranged in the first direction, and

a plurality of arrays in which a plurality of fifth units different from the fourth units are arranged in the first direction;

the fourth region has a conductive pattern including

a plurality of arrays in which the plurality of fourth units are arranged in the second direction, and

a plurality of arrays in which the plurality of fifth units are arranged in the second direction;

the first region and the third region are different from each other in at least one of a spacing between the arrays of the conductive pattern, a shape of the unit included in the array, a dimension of the unit, and a spacing between the units; and

the second region and the fourth region are different from each other in at least one of a spacing between the arrays of the conductive pattern, a shape of a unit included in the array, a dimension of the unit, and a spacing between the units.

6. The electromagnetic wave absorbing member according to claim 5, wherein

the third region includes a plurality of arrays in which a plurality of sixth units different from both the fourth units and the fifth units are arranged in the first direction, and

the fourth region includes a plurality of arrays in which a plurality of the sixth units are arranged in the second direction.

7. The electromagnetic wave absorbing member according to claim 5 or 6, wherein the third region and the fourth region are repeatedly arranged at regular spacings.

8. The electromagnetic wave absorbing member according to any one of claims 1 to 7, wherein the conductive pattern of the fourth region is a pattern obtained by at least rotating or inverting the conductive pattern of the third region.

9. The electromagnetic wave absorbing member according to any one of claims 5 to 8, wherein the first region is arranged so as to be adjacent to at least one of the third region and the fourth region and not to be adjacent to the second region.

10. The electromagnetic wave absorbing member according to any one of claims 5 to 8, wherein the first region is arranged so as to be adjacent to at least one of the second region and the fourth region and not to be adjacent to the third region.

11. The electromagnetic wave absorbing member according to any one of claims 1 to 10, further comprising a fifth region that has a conductive pattern including a plurality of the first arrays and a plurality of the second arrays, wherein

in the fifth region,

a plurality of the first units and a plurality of the second units are arranged in a third direction different from both the first direction and the second direction, and

the first array and the second array are arranged adjacent to each other.

12. The electromagnetic wave absorbing member according to any one of claims 1 to 11, further comprising a spacer layer and a reflective layer.

Fig. 1

EP 4 788 078 A1

Fig. 2

Fig. 3

Fig. 4

Fig. 5

Fig. 6

Fig. 7

Fig. 8

Fig. 9

## INTERNATIONAL SEARCH REPORT

| International application No. |
| --- |
| **PCT/JP2024/029284** |

| A. | CLASSIFICATION OF SUBJECT MATTER |
| --- | --- |

*H05K 9/00*(2006.01)i; *H01Q 15/14*(2006.01)i; *H01Q 17/00*(2006.01)i
FI: H05K9/00 M; H01Q15/14 B; H01Q15/14 Z; H01Q17/00

According to International Patent Classification (IPC) or to both national classification and IPC

| B. | FIELDS SEARCHED |
| --- | --- |

Minimum documentation searched (classification system followed by classification symbols)

H05K9/00; H01Q15/14; H01Q17/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 2020-38878 A (LINTEC CORPORATION) 12 March 2020 (2020-03-12) paragraphs [0059]-[0070], fig. 1-4 | 1-4, 12 |
| A | | 5-11 |
| Y | JP 2007-143132 A (NITTA CORPORATION) 07 June 2007 (2007-06-07) paragraphs [0211]-[0213], fig. 39 | 1-4, 12 |
| Y | JP 2022-56768 A (LINTEC CORPORATION) 11 April 2022 (2022-04-11) paragraphs [0015]-[0017], fig. 3 | 1-4, 12 |
| A | JP 2004-53466 A (THE YOKOHAMA RUBBER CO., LTD.) 19 February 2004 (2004-02-19) entire text, all drawings | 5-11 |
| A | JP 2016-4544 A (DAI NIPPON PRINTING CO., LTD.) 12 January 2016 (2016-01-12) entire text, all drawings | 5-11 |
| A | JP 2005-184012 A (NITTA CORPORATION) 07 July 2005 (2005-07-07) entire text, all drawings | 5-11 |

☐ Further documents are listed in the continuation of Box C.    ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **18 October 2024** | **29 October 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/029284**

| Patent document cited in search report | | | Publication date (day/month/year) | Patent family member(s) | Publication date (day/month/year) |
|---|---|---|---|---|---|
| JP | 2020-38878 | A | 12 March 2020 | (Family: none) | |
| JP | 2007-143132 | A | 07 June 2007 | US 2010/0052992 A1 paragraphs [0259]-[0261], fig. 39 <br> EP 2096711 A1 <br> TW 200723596 A | |
| JP | 2022-56768 | A | 11 April 2022 | (Family: none) | |
| JP | 2004-53466 | A | 19 February 2004 | (Family: none) | |
| JP | 2016-4544 | A | 12 January 2016 | (Family: none) | |
| JP | 2005-184012 | A | 07 July 2005 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6861907 B